# EUROPEAN PATENT SPECIFICATION

(11) **EP 3 822 619 B1**
(45) Date of publication and mention of the grant of the patent: **03.12.2025**
(21) Application number: 18926268.6
(22) Date of filing: 13.07.2018
(51) Int. Cl.: G01N 21/95, H05K 13/08

(54) **FOREIGN MATTER DETECTION METHOD AND ELECTRONIC COMPONENT MOUNTING DEVICE**
VERFAHREN UND VORRICHTUNG ZUR DETEKTION VON FREMDSTOFFEN
PROCÉDÉ DE DÉTECTION DE MATIÈRE ÉTRANGÈRE ET DISPOSITIF DE MONTAGE DE COMPOSANT ÉLECTRONIQUE

(43) Date of publication of application: 19.05.2021
(73) Proprietor: Fuji Corporation, Chiryu-shi, Aichi 472-8686 (JP)
(72) Inventor: KITO, Shuichiro, Chiryu-shi, Aichi 472-8686 (JP)
(74) Representative: Grünecker Patent- und Rechtsanwälte PartG mbB
(86) International application number: PCT/JP2018/026447
(87) International publication number: WO 2020/012628

(56) References cited:
- WO-A1-2017/081736
- WO-A1-2017/081736
- WO-A1-2018/042590
- JP-A- 2004 061 460
- JP-A- H0 575 296
- JP-A- H09 265 536
- JP-A- H11 132 758
- JP-A- H11 132 758
- JP-A- H11 166 899
- JP-A- H11 166 899
- JP-U- H0 520 396
- JP-U- H0 643 561
- US-A- 5 910 844

## Description

### Technical Field

The present invention relates to a foreign matter detection method and an electronic component mounting device.

### Background Art

Conventionally, there is an inspection technique, for example, using an image obtained by imaging an electronic component, which is employed for an electronic component mounting device to mount the electronic component on a board by picking up the electronic component with a suction nozzle. For example, Patent Literature 1 discloses a technique that detects positions of an electrode and an insertion pin of the electronic component based on an image obtained by imaging the electronic component with the insertion pin, and determines whether a relative position of the insertion pin with respect to a component center calculated by the electrode position is within an allowable range.

### Patent Literature

Patent Literature 1: JP-A-11-145600
WO 2018 042590 A1 discloses a component mounting apparatus with a tolerance checking mode, wherein the position of a lead is identified along with the determination of whether or not the size of a lead region is within a tolerance range. The lead region is determined based on a collection region of pixels for which the binarized value is a value of a color indicating the lead.

### Summary of the Invention

### Technical Problem

There is a case where a lead is cut to a predetermined length before being mounted on a board in the lead component, which turns out generating burrs at a tip end of the lead at the cutting. When mounting to the board, the burrs may come off from the lead and adhere to the board. Therefore, a technique for detecting foreign matters such as burrs adhering to the lead of a lead component prior to mounting to the board has been requested.

The present application has been proposed in view of the above-described problems, and an object thereof is to provide a technique capable of detecting the foreign matter adhering to the lead of the lead component.

### Solution to Problem

This object is solved by the subject matter of the independent claims.

Embodiments are defined by the dependent claims.

### Advantageous Effect of the Invention

According to the present disclosure, it is possible to provide a foreign matter detection method and an electronic component mounting device capable of detecting a foreign matter adhered to a lead of a lead component.

### Brief Description of Drawings

Fig. 1 is a perspective view showing an electronic component mounting device.
Fig. 2 is a perspective view showing a feed device and a cutting device.
Fig. 3 is a schematic diagram of a part camera.
Fig. 4 is a diagram showing a captured image of a lead to which no foreign matter adheres.
Fig. 5 is a block diagram showing a control system of the electronic component mounting device.
Fig. 6 is a schematic diagram showing a lead to which a foreign matter has adhered.
Fig. 7 is a diagram showing a captured image of a lead to which a foreign matter adheres.
Fig. 8 is a flowchart of foreign matter detection process.
Fig. 9 is a diagram for explaining a positional relationship between the lead and a through hole.
Fig. 10 is a diagram for explaining a detection range.
Fig. 11 is a graph showing a result of an integrated brightness in the foreign matter detection process.

### Description of Embodiments

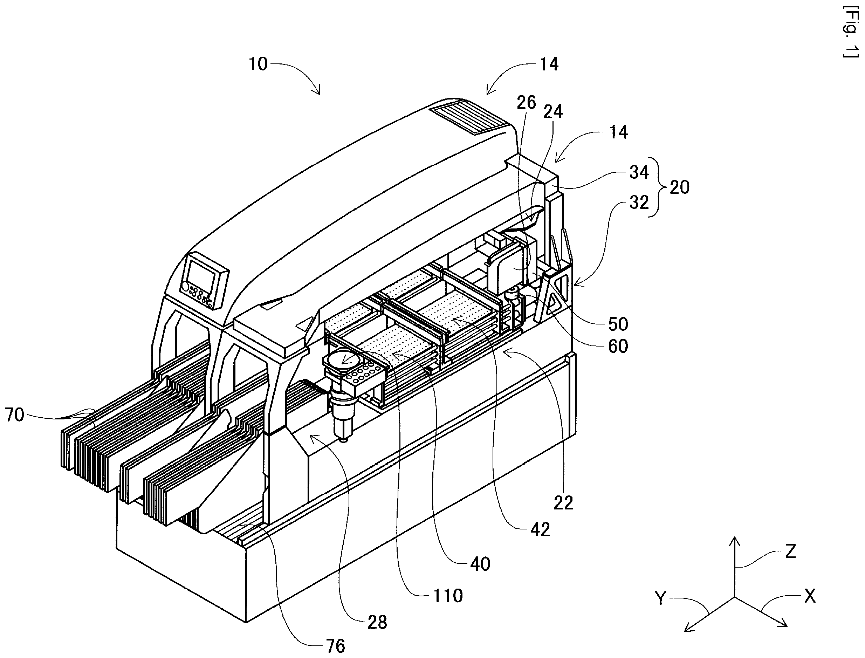

Fig. 1 shows electronic component mounting device 10. Electronic component mounting device 10 is configured with two component mounters (hereinafter, abbreviated as "mounter") 14. Each mounter 14 mainly includes mounter main body 20, conveyance device 22, moving device 24, mounting head 26, supply device 28, and part camera 110.

Mounter main body 20 includes frame portion 32 and beam portion 34 which is provided above frame portion 32. Conveyance device 22 includes two conveyor devices 40 and 42. Each of two conveyor devices 40 and 42 conveys a board such as a printed circuit board, supported on each conveyor device 40 and 42. In the following description, a conveyance direction of the board is referred to as an X direction, a horizontal direction perpendicular to the direction is referred to as a Y direction, and a vertical direction is referred to as a Z direction.

Moving device 24 is an XY-robot type moving device, and moves slider 50 to any position. Mounting head 26 is attached to slider 50 so that mounting head 26 is moved to any position on frame portion 32. Mounting head 26 has suction nozzle 60 provided on a lower end surface. Suction nozzle 60 picks up and holds the electronic component by negative pressure, and releases the held electronic component by positive pressure.

Mounting head 26 is for mounting the electronic component with respect to the board. Suction nozzle 60 is provided on the lower end surface of mounting head 26. Suction nozzle 60 communicates with a positive and negative pressure supply device (not shown) via negative pressure air passage and positive pressure air passage. Thus, suction nozzle 60 picks up and holds the electronic component by negative pressure, and releases the held electronic component by positive pressure. Furthermore, mounting head 26 has a nozzle lifting and lowering device (not shown) for lifting and lowering suction nozzle 60, and changes the position in an up-down direction of the electronic component to be held.

Part camera 110 is disposed between conveyance device 22 and supply device 28 and images the electronic component held by mounting head 26.

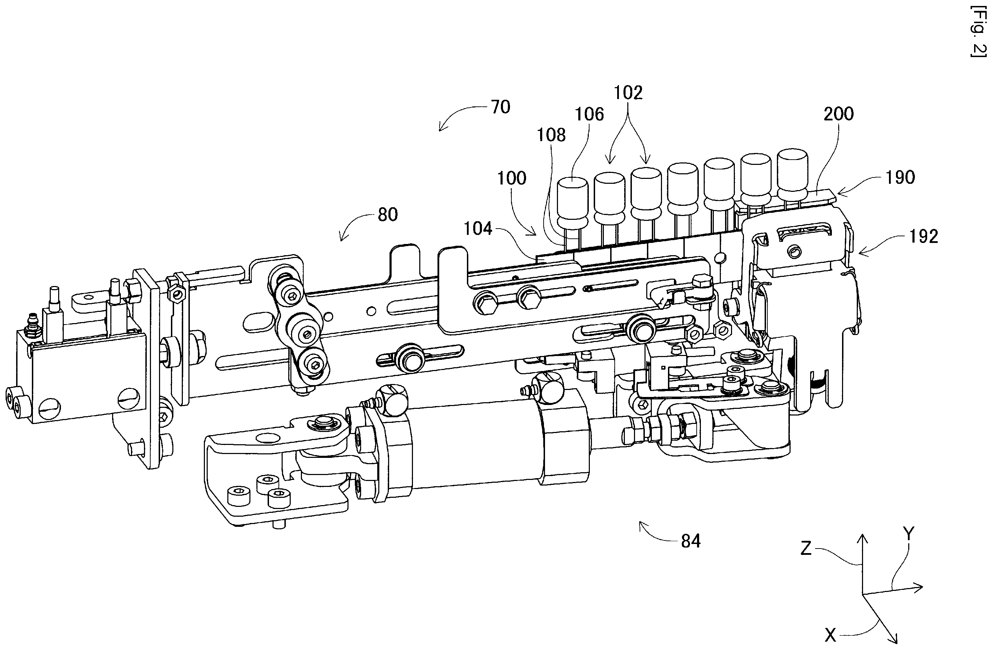

Next, tape feeder 70 for supplying radial component 102 will be described with reference to Fig. 2. Tape feeder 70 holds taped component 100 to which radial component 102 is taped. Radial component 102 has main body portion 106 and two leads 108 extending in the same direction from a bottom surface of main body portion 106. In taped component 100, the lower end portions of two leads 108 are taped with carrier tape 104. Tape feeder 70 includes cutting device 84, feed device 80, and the like. In the description of tape feeder 70, a side where cutting device 84 is disposed is described as a front side, and an opposite side to the front side is described as a rear side.

Feed device 80 draws taped component 100 forward of tape feeder 70 by parallelizing an axis of lead 108 and a Z-axis. Cutting device 84 includes fixing member 190, swing member 192, fixed-side clamping plate 200, and the like. The movable blade (not shown) is fixed to an upper end surface of swing member 192. Lead 108 of radial component 102 is inserted between an upper end portion of fixing member 190 and the upper end portion of swing member 192 by feed device 80. By swinging the upper end portion of swing member 192 in a direction of approaching fixing member 190, cutting device 84 cuts lead 108 that is inserted between the upper end portion of fixing member 190 and the upper end portion of swing member 192 by the movable blade. As described above, radial component 102 in which lead 108 is cut to a predetermined length is supplied by tape feeder 70.

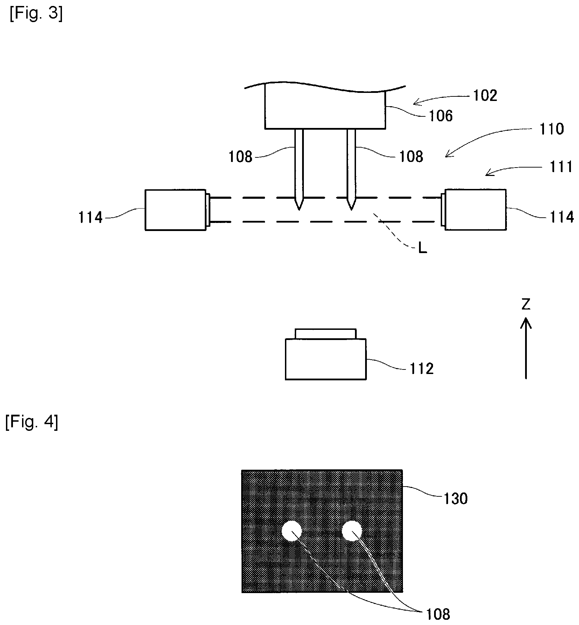

Part camera 110 will be described in detail with reference Fig. 3 by taking radial component 102 as an example. Part camera 110 includes irradiation section 111 and imaging section 112. Imaging section 112 is disposed below irradiation section 111 and images radial component 102 emitted by irradiation section 111 from below. Irradiation section 111 has, for example, four light emitting sections 114 so as to surround imaging section 112 when viewed from above. Light emitting section 114 has, for example, a laser light source, and is disposed to project toward imaging section 112 when viewed from above. In addition, light emitting section 114 emits light L having a predetermined width when viewed from a side. During imaging, radial component 102 held by mounting head 26 is moved such that radial component is above imaging section 112 when viewed from above, and the lead portion including a tip end of lead 108 is located in light L when viewed from the side. Light L emitted from light emitting section 114 is reflected at the tip end of lead 108, and the reflected light enters imaging section 112. Therefore, image 130 captured by imaging section 112, as shown in Fig. 4, is an image with high brightness in a portion of lead 108. As described later, based on captured image 130, the position of lead 108 is specified, and a mounting position in the board is corrected by control device 140. In the following description, there is a case where the image captured by imaging section 112 may be referred to as a captured image.

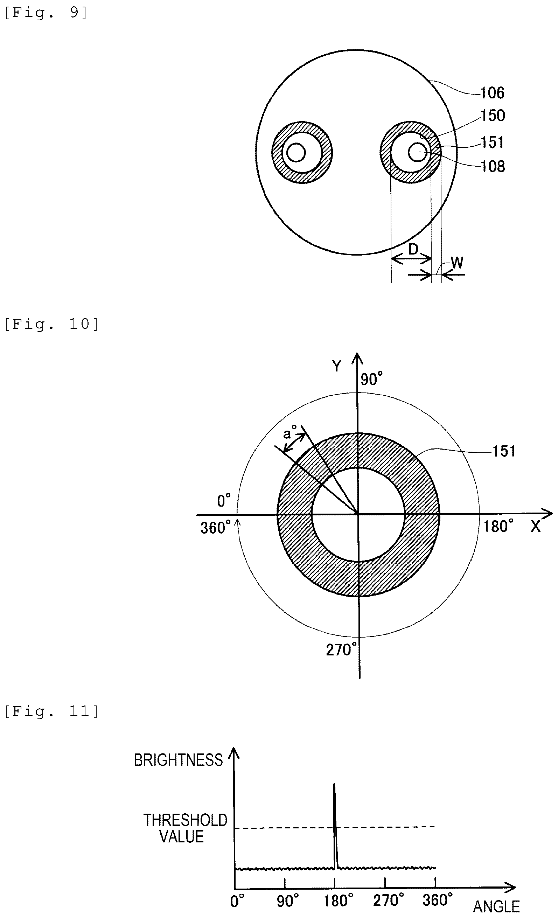

Next, a mounting work of mounter 14 will be described with reference to radial component 102. The board is conveyed to a predetermined position by conveyor devices 40 and 42, and is fixed by board holding device 48. On the other hand, moving device 24 moves mounting head 26 to supply device 28. Next, suction nozzle 60 is lowered to the position of radial component 102 of which lead 108 is cut, radial component 102 being fed by supply device 28, and picks up and holds radial component 102. Thereafter, suction nozzle 60 is lifted up. Next, moving device 24 moves mounting head 26 to the position of part camera 110, and part camera 110 images radial component 102. Moving device 24 moves mounting head 26 above the mounting position of the board. Suction nozzle 60 descends to the board position and releases radial component 102 in a state where lead 108 is inserted into through hole 150 (Fig. 9) of the board. In this manner, mounting head 26 mounts radial component 102 to the board.

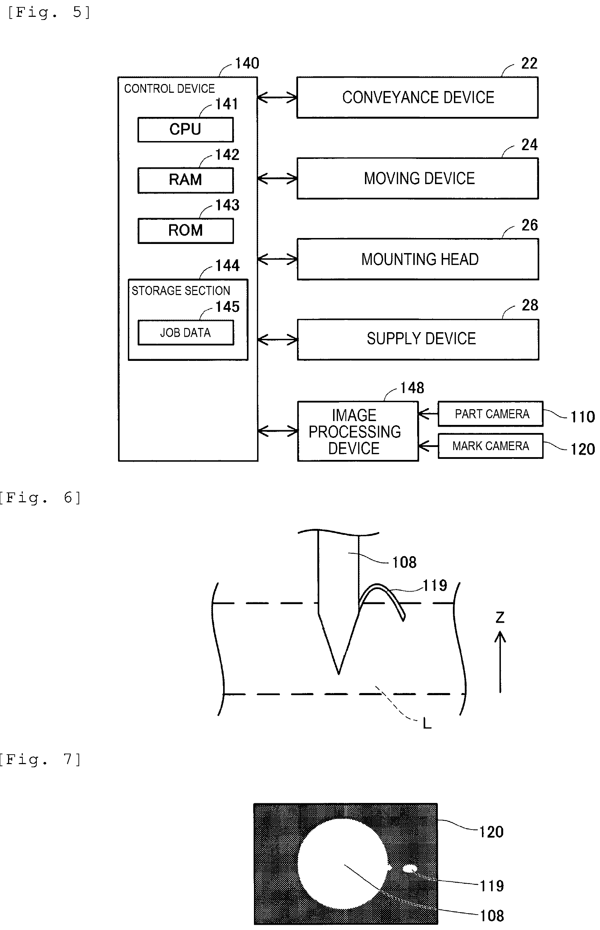

Using Fig. 5, a description will be given of the configuration of a control system of mounter 14. In addition to the above-described configuration, mounter 14 includes control device 140, image processing device 148, mark camera 120, and the like. Control device 140 includes CPU 141, RAM 142, ROM 143, storage section 144, and the like. CPU 141 controls each of the electrically connected parts by executing various programs stored in ROM 143. Here, each of the parts is conveyance device 22, moving device 24, mounting head 26, supply device 28, image processing device 148, and the like. RAM 142 is used as a main storage device for CPU 141 to execute various processes. Control programs and various data are stored in ROM 143. Storage section 144 is realized using a flash memory, for example, and job data 145, various types of information, and the like are recorded thereon. Job data 145 includes information on a work procedure of the mounting work, and control device 140 controls each part in accordance with job data 145 to perform the mounting work. In addition to the above, job data 145 includes information such as a diameter of lead 108 of radial component 102, a diameter of through hole 150 in the board, and the mounting position of radial component 102 on the board.

Mark camera 120 is fixed to the lower surface of slider 50 in a state of facing downward and images a fiducial mark for board positioning formed on the board, for example. Image processing device 148 is realized by, for example, a computer, and performs image processing with respect to the captured image data captured by mark camera 120 and part camera 110. More specifically, the position of an outer shape of, for example, an electronic component included in the image data is digitized and the digitized data is output to CPU 141.

Since lead 108 is cut by cutting device 84, burrs are generated on a cut surface, or chips adhered to the movable blade in the preceding cutting may adhere to lead 108 at the time of contact. In the following description, such burrs, chips, and the like are collectively referred to as a foreign matter. Here, the foreign matter is not limited to the above case, and may be a matter that deviates from the original shape of lead 108. The foreign matter may come off from lead 108 and adhere to the board when mounting to the board. A method of detecting the foreign matter adhered to lead 108 of radial component 102 prior to mounting on the board will be described next.

First, an outline of the detection method will be described. In a case where foreign matter 119 adheres, since light L is reflected by foreign matter 119, the image captured by part camera 110 is an image with high brightness in foreign matter 119 portion. Therefore, in this detection method, a presence or absence of foreign matter 119 is determined depending on the presence or absence of a portion having a high brightness other than lead 108 in the image captured by part camera 110. Incidentally, the positions where foreign matter 119 adheres to lead 108 are various. For example, in a case where foreign matter 119 adheres to the tip end portion of lead 108, the image of lead 108 and the image of foreign matter 119 are continuous images. Further, for example, when foreign matter 119 having a shape as shown in Fig. 6 adheres, foreign matter 119 is imaged at a position away from lead 108 as shown in Fig. 7. This is because light L emitted from light emitting section 114 is light having a predetermined width, and thus only a portion irradiated with light L is imaged. As described above, depending on the position where foreign matter 119 adheres, foreign matter 119 may be imaged at a position away from lead 108. In the mounting work, the position of lead 108 is specified by detecting the edge with a caliper tool using the captured image. However, in the caliper tool for specifying the position of lead 108, it is particularly difficult to detect foreign matter 119 imaged at a position away from lead 108. Next, a detection method capable of detecting foreign matter 119 imaged at a position away from lead 108 will be described.

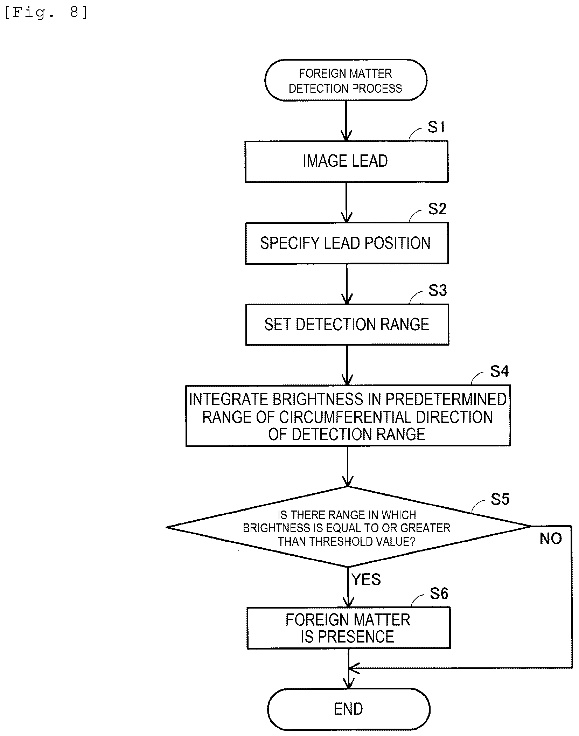

The detection method will be described in detail. Control device 140 and image processing device 148 cooperatively execute the foreign matter detection process shown in Fig. 8 to detect foreign matter 119. Control device 140 executes the foreign matter detection process in accordance with job data 145. First, control device 140 causes irradiation section 111 to irradiate the lead portion including the tip end of lead 108 of radial component 102 held by mounting head 26 with light L from the side, and causes imaging section 112 to image lead 108 which is irradiated with light L from below (S1). Next, image processing device 148 specifies a position of lead 108 based on the image data transmitted from imaging section 112 of part camera 110 (S2). More specifically, for example, a center position of lead 108 is specified. Next, based on the position of through hole 150 to be mounted on the board, a detection range is set in the image for detecting the foreign matter (S3).

Step S3 will be described with reference to Fig. 9. Fig. 9 is a diagram of the same viewpoint as the captured image, that is, when radial component 102 being viewed in the direction from the tip end of lead 108 toward main body portion 106. When the center position of lead 108 is specified by the captured image, the position of through hole 150 to be mounted is determined in the captured image based on the center position of lead 108. Detection range 151 is an annular range having width W with the outer periphery of through hole 150 having diameter D as an inner periphery. Here, the reason that detection range 151 is set as the annular range with the outer periphery of through hole 150 as the inner periphery is not to take foreign matter 119 in the range that can pass through through hole 150 as an error. This is because, even though foreign matter 119 adheres to lead 108, if it is possible to pass through through hole 150, the possibility of contact with through hole 150 is low, and the possibility of foreign matter 119 to come off from lead 108 is low.

Next, the brightness of annular detection range 151 is integrated for each predetermined range (S4 and Fig. 8). Step S4 will be described with reference to Fig. 10. Here, coordinates shown in Fig. 10 will be used for explanation. That is, the center of detection range 151 is an origin, a right direction of the paper surface is an X-axis, and an upper direction is a Y-axis. Here, the X-axis negative direction is 0°, and the angle is defined clockwise. In step S4, detection range 151 is divided into a fan-shaped range having a central angle of angle a°, and the brightness of the fan-shaped range is integrated. Data in which the integrated brightness and the angle are associated is generated. a° shown in Fig. 10 does not limit a magnitude of the angle. Fig. 11 shows a graph of data in which the integrated brightness data is associated with the angle. A horizontal axis is the angle and a vertical axis is the brightness shown in Fig. 11. As shown in Fig. 11, for example, in a case where foreign matter 119 is at an angle 180°, the brightness of the corresponding range increases. In the foreign matter detection process, the presence or absence of the foreign matter is determined depending on the presence or absence of brightness equal to or greater than a threshold value.

Returning to Fig. 8, image processing device 148 determines whether there is a range in which the integrated brightness is equal to or greater than the threshold value (S5). In a case where it is determined that there is a range in which the brightness is equal to or greater than the threshold value (S5:YES), the fact that foreign matter 119 is detected is transmitted to control device 140 (S6), and the foreign matter detection process is ended. When it is transmitted that foreign matter 119 is detected, control device 140, as an error, does not perform the mounting work of radial component 102. On the other hand, in a case where it is determined that there is no range in which the brightness is equal to or greater than the threshold value (S5:NO), the foreign matter detection process is ended. In a case where the result in step S5 is determined to be No, based on the specified position of the lead, the position of held radial component 102 is corrected, lead 108 is inserted into through hole 150, and it is mounted to the board.

In the above embodiment, image processing device 148 is an example of an image processing section. Step S1 is an example of an irradiation step and an imaging step, step S2 is an example of a specifying step, and steps S3 to S6 are examples of a detection step. Detection range 151 is an example of a predetermined region. The threshold value in step S5 is an example of a predetermined value.

According to the embodiment described above, the following effects are obtained. Irradiation section 111 irradiates the lead portion including the tip end of lead 108 of radial component 102 held by mounting head 26 with light L from the side. Imaging section 112 images lead 108 irradiated with light L from below. Image processing device 148 specifies the position of lead 108 based on the image data (S3), sets detection range 151 based on the specified position of lead 108 (S3), and detects foreign matter 119 based on the change in brightness in detection range 151. Since a portion including the tip end of lead 108 is irradiated with light L, in a case where foreign matter 119 adheres to lead 108, the captured image becomes an image in which the brightness of lead 108 and the portion of the foreign matter adhered to lead 108 is high. Therefore, foreign matter 119 adhered to lead 108 can be detected based on the change in brightness in detection range 151 with the position of lead 108 as a reference.

Detection range 151 is a region that does not include the occupied region of lead 108, and has width W with the outer periphery of through hole 150 into which lead 108 is to be inserted as the inner periphery. As a result, it is possible to detect foreign matter 119 that cannot pass through through hole 150. By setting detection range 151 as a region that does not include the occupied region of lead 108 in advance, it is possible to exclude a region having high brightness corresponding to a reflection at lead 108 in the captured image and efficiently extract only a region having high brightness corresponding to a reflection at foreign matter 119. In addition, by limiting to the region having width W, the amount of image data can be reduced and the load of the processing can be reduced.

Further, image processing device 148 integrates the brightness in a predetermined range along the circumferential direction of detection range 151 (S4), it is determined whether the integrated brightness is equal to or greater than the threshold value (S5), and when it is equal to or greater than the threshold value, there is a foreign matter (S6). As a result, it is possible to detect foreign matter 119 based on whether the integrated brightness is equal to or greater than the threshold value.

Next, another example of the foreign matter detection process will be described. Unlike the above steps S4 and S5, a binarization process may be performed on the captured image in detection range 151 using a threshold value, and a foreign matter may be detected depending on a the presence or absence of a region having brightness equal to or greater than the threshold value. As a result, foreign matter 119 can be detected depending on the presence or absence of a region having brightness equal to or greater than the threshold value in the binarization process.

In the above, the detection range 151 according to the invention has been described as a range with the outer periphery of through hole 150 as the inner periphery. Next, another embodiment of detection range 151 that is not part of the invention will be described, wherein the detection range 151 has a predetermined width with the outer periphery of lead 108 as the inner periphery. Accordingly, foreign matter 119 adhered to lead 108 can be detected regardless of the shape of through hole 150. Even if foreign matter 119 can pass through through hole 150, there is a possibility of falling during movement to the mounting position of the board by mounting head 26. In this case, foreign matter 119 adhering to lead 108 can be detected by setting a range having the predetermined width with the outer periphery of lead 108 as the inner periphery. In the case of this configuration, a circular region having the diameter of lead 108 included in job data 145 as the outer periphery with respect to the specified center position of lead 108 may be used as the occupied region of lead 108.

In addition, according to the invention, the detection range 151 is an annular shape. According to an embodiment that is not part of the invention, the detection range 151 may be matched to the shape of through hole 150 or the cross-sectional shape of the lead. For example, if through hole 150 has a rectangular shape, it may be a range surrounded by a rectangle.

Further, in the above, as a specific acquisition method of the amount of change in brightness, a method of using a value obtained by integrating the brightness for each predetermined range having a predetermined central angle has been described, but it is not limited thereto. Brightness change amount in the circumferential direction and the brightness gradient may be calculated, and for example, detection range 151 is further divided into multiple annular regions, and the brightness change amount in the circumferential direction and the brightness gradient may be calculated for each annular region.

### Reference Signs List

10 electronic component mounting device, 26 mounting head, 102 radial component, 108 lead, 111 irradiation section, 112 imaging section, 140 control device, 148 image processing device, 151 detection range

## Claims

1. A foreign matter detection method comprising:
an irradiation step of irradiating light to a lead portion including a lead tip end of a lead component (102), the light being irradiated from a side of the lead component (102);
an imaging step (S1) of imaging a lead (108) irradiated with the light from below;
a specifying step (S2) of specifying a position of the lead (108) based on a captured image; and
a detection step (S6) of detecting a foreign matter (119) based on a change in brightness in the image of a predetermined region (151) based on the specified position of the lead (108),
wherein the predetermined region (151) is an annular range having a predetermined radial thickness (W), wherein an inner periphery of the annular range corresponds to an outer periphery (D) of a through hole (150) into which the lead (108) is to be inserted.

2. The foreign matter detection method according to claim 1, wherein the predetermined region (151) is a region that does not include an occupied region of the lead (108) and has the predetermined radial thickness (W) with a center position of the lead (108) as a center.

3. The foreign matter detection method according to claim 1 or 2, wherein a binarization process is performed on the image of the predetermined region (151) using a threshold value, and the foreign matter (119) is detected depending on a presence or absence of a region equal to or greater than the threshold value.

4. The foreign matter detection method according to claim 1 or 2, wherein the foreign matter (119) is detected based on whether an amount of change in brightness in a direction along a circumference of the predetermined region (151) in the image of the predetermined region is equal to or greater than a predetermined value.

5. An electronic component mounting device (10) comprising:
a mounting head (26) configured to hold a lead component (102);
an irradiation section (111) configured to irradiate light to a lead portion including a lead tip end of the lead component (102) held by the mounting head (26), the light being irradiated from a side of the lead component (102);
an imaging section (112) disposed below the irradiation section (111) and configured to image a lead (108) irradiated with the light from below; and
an image processing section (148) configured to process an image captured by the imaging section (112),
wherein the image processing section (148) is configured to specify a position of the lead (108) based on the image, and is configured to detect a foreign matter (119) based on a change in brightness in the image of a predetermined region (151) based on the specified position of the lead (108)
wherein the predetermined region (151) is an annular range having a predetermined radial thickness (W), wherein an inner periphery of the annular range corresponds to an outer periphery (D) of a through hole (150) into which the lead (108) is to be inserted.

## Patentansprüche

1. Verfahren zur Fremdkörpererkennung, umfassend:
einen Bestrahlungsschritt, bei dem Licht auf einen Leitungsabschnitt einschließlich eines Leitungsspitzenendes einer Leitungskomponente (102) gestrahlt wird, wobei das Licht von einer Seite der Leitungskomponente (102) gestrahlt wird;
einen Bildgebungsschritt (S1) zum Abbilden einer Leitung (108), die mit dem Licht von unten bestrahlt wird;
einen Spezifizierungsschritt (S2) zum Spezifizieren einer Position der Leitung (108) auf der Grundlage eines aufgenommenen Bildes; und
einen Erkennungsschritt (S6) zum Erkennen eines Fremdkörpers (119) auf der Grundlage einer Helligkeitsänderung in dem Bild eines vorbestimmten Bereichs (151) auf der Grundlage der bestimmten Position der Leitung (108),
wobei der vorbestimmte Bereich (151) ein ringförmiger Bereich mit einer vorbestimmten radialen Dicke (W) ist, wobei ein innerer Umfang des ringförmigen Bereichs einem Außenumfang (D) eines Durchgangslochs (150) entspricht, in das die Leitung (108) eingeführt werden soll.

2. Verfahren zur Fremdkörpererkennung nach Anspruch 1, wobei der vorbestimmte Bereich (151) ein Bereich ist, der keinen belegten Bereich der Leitung (108) umfasst und die vorbestimmte radiale Dicke (W) mit einer Mittelposition der Leitung (108) als Mittelpunkt aufweist.

3. Verfahren zur Fremdkörpererkennung nach Anspruch 1 oder 2, wobei ein Binarisierungsprozess an dem Bild des vorbestimmten Bereichs (151) unter Verwendung eines Schwellenwerts durchgeführt wird und der Fremdkörper (119) in Abhängigkeit vom Vorhandensein oder Fehlen eines Bereichs erkannt wird, der gleich oder größer als der Schwellenwert ist.

4. Verfahren zur Fremdkörpererkennung gemäß Anspruch 1 oder 2, wobei der Fremdkörper (119) auf der Grundlage erkannt wird, ob eine Änderung der Helligkeit in einer Richtung entlang eines Umfangs des vorbestimmten Bereichs (151) in dem Bild des vorbestimmten Bereichs gleich oder größer als ein vorbestimmter Wert ist.

5. Elektronische Bauteil-Montagevorrichtung (10), umfassend:
einen Befestigungskopf (26), der so konfiguriert ist, dass er eine Anschlussbauteil (102) hält;
einen Bestrahlungsabschnitt (111), der so konfiguriert ist, dass er Licht auf einen Anschlussabschnitt einschließlich eines Anschluss-Spitzenendes der vom Montagekopf (26) gehaltenen Anschlussbauteils (102) bestrahlt, wobei das Licht von einer Seite des Anschlussbauteils (102) bestrahlt wird;
einen Bildgebungsabschnitt (112), der unterhalb des Bestrahlungsabschnitts (111) angeordnet ist und so konfiguriert ist, dass er eine Leitung (108), die mit dem Licht von unten bestrahlt wird, abbildet; und
einen Bildverarbeitungsabschnitt (148), der so konfiguriert ist, dass er ein vom Bildgebungsabschnitt (112) aufgenommenes Bild verarbeitet,
wobei der Bildverarbeitungsabschnitt (148) so konfiguriert ist, dass er eine Position der Leitung (108) auf der Grundlage des Bildes bestimmt, und so konfiguriert ist, dass er ein Fremdmaterial (119) auf der Grundlage einer Änderung der Helligkeit in dem Bild eines vorbestimmten Bereichs (151) auf der Grundlage der bestimmten Position der Leitung (108) erkennt
wobei der vorbestimmte Bereich (151) ein ringförmiger Bereich mit einer vorbestimmten radialen Dicke (W) ist, wobei ein innerer Umfang des ringförmigen Bereichs einem Außenumfang (D) eines Durchgangslochs (150) entspricht, in das die Leitung (108) eingeführt werden soll.

## Revendications

1. Procédé de détection de matière étrangère comprenant :
une étape d'irradiation consistant à irradier de la lumière vers une partie de conducteur comportant une extrémité en pointe de conducteur d'un composant de conducteur (102), la lumière étant irradiée depuis un côté du composant de conducteur (102) ;
une étape d'imagerie (S1) consistant à imager un conducteur (108) irradié par la lumière par le bas ;
une étape de spécification (S2) consistant à spécifier une position du conducteur (108) sur la base d'une image capturée ; et
une étape de détection (S6) consistant à détecter une matière étrangère (119) sur la base d'une variation de luminosité de l'image d'une région prédéterminée (151) sur la base de la position spécifiée du conducteur (108),
dans lequel la région prédéterminée (151) est une plage annulaire ayant une épaisseur radiale prédéterminée (W), dans lequel une périphérie intérieure de la plage annulaire correspond à une périphérie extérieure (D) d'un trou traversant (150) dans lequel le conducteur (108) doit être inséré.

2. Procédé de détection de matière étrangère selon la revendication 1, dans lequel la région prédéterminée (151) est une région qui ne comporte aucune région occupée du conducteur (108) et qui a l'épaisseur radiale prédéterminée (W) avec une position centrale du conducteur (108) comme centre.

3. Procédé de détection de matière étrangère selon la revendication 1 ou 2, dans lequel un processus de binarisation est effectué sur l'image de la région prédéterminée (151) à l'aide d'une valeur seuil, et la matière étrangère (119) est détectée en fonction d'une présence ou absence d'une région égale ou supérieure à la valeur seuil.

4. Procédé de détection de matière étrangère selon la revendication 1 ou 2, dans lequel la matière étrangère (119) est détectée sur la base qu'une quantité de variation de luminosité dans une direction le long d'une circonférence de la région prédéterminée (151) dans l'image de la région prédéterminée est égale ou supérieure à une valeur prédéterminée.

5. Dispositif de montage de composant électronique (10) comprenant :
une tête de montage (26) configurée pour soutenir un composant de conducteur (102) ;
une section d'irradiation (111) configurée pour irradier de la lumière vers une partie de conducteur comportant une extrémité en pointe de conducteur du composant de conducteur (102) soutenue par la tête de montage (26), la lumière étant irradiée depuis un côté du composant de conducteur (102) ;
une section d'imagerie (112) disposée au-dessous de la section d'irradiation (111) et configurée pour imager un conducteur (108) irradié par la lumière par le bas ; et
une section de traitement d'image (148) configurée pour traiter une image capturée par la section d'imagerie (112),
dans lequel la section de traitement d'image (148) est configurée pour spécifier une position du conducteur (108) sur la base de l'image, et est configurée pour détecter une matière étrangère (119) sur la base d'une variation de luminosité de l'image d'une région prédéterminée (151) sur la base de la position spécifiée du conducteur (108)
dans lequel la région prédéterminée (151) est une plage annulaire ayant une épaisseur radiale prédéterminée (W), dans lequel une périphérie intérieure de la plage annulaire correspond à une périphérie extérieure (D) d'un trou traversant (150) dans lequel le conducteur (108) doit être inséré.
